# EUROPÄISCHE PATENTANMELDUNG

(11) **EP 1 098 395 A2**
(43) Veröffentlichungstag der Anmeldung: **09.05.2001**
(21) Anmeldenummer: 00122234.8
(22) Anmeldetag: 17.10.2000
(51) Int. Cl.: H01R 12/38

(54) **Kontakt für Leiterfolien**

(30) Priorität: 02.11.1999 DE 19952752
(71) Anmelder: Harting Automotive GmbH & Co. KG, 32339 Espelkamp (DE)
(72) Erfinder: Harting, Dietmar, 32399 Espelkamp (DE); Mouissie, Bob, Dipl.-Ing., 5258 EK Berlicum (NL); Krause, Jens, Dr.-Ing., 32369 Rahden (DE); Heimann, Thomas Dipl.-Ing., 32399 Espelkamp (DE)
(74) Vertreter: Sties, Jochen, Dipl.-Ing.

(57) **Zusammenfassung**

Bei einem Kontakt für Leiterfolien, die mindestens eine Leiterbahn (14) enthalten, soll eine besonders zuverlässige Kontaktierung über lange Zeiträume gewährleistet sein. Zu diesem Zweck ist der Kontakt mit einem Andruckelement (16) versehen, das mit einem Vorsprung (24) versehen ist, der eine durchgehende Andruckfläche (25) aufweist, und mit einem Gegendruckelement (18), das mit einer Aussparung (28) versehen ist, deren Kontur an die Gestalt der Andruckfläche angepaßt ist, wobei der Vorsprung elastisch gegen das Gegendruckelement beaufschlagt wird, so daß eine zu kontaktierende Leiterfolie zwischen der Andruckfläche (25) und dem Rand der Aussparung (28) eingespannt wird. Dies ermöglicht es, auch bei einem eventuellen Fließen der Leiterfolie eine konstante Kontaktkraft aufrechtzuerhalten.

## Beschreibung

Die Erfindung betrifft einen Kontakt für Leiterfolien.

Es ist ein Kontaktelement von der Firma Dupont bekannt, das dazu dient, eine Kontaktierung der Leiterbahn der Leiterfolie an einer beliebigen Stelle zu ermöglichen, um beispielsweise ein Kabel an die Leiterbahn anzuschließen oder eine Verbindung mit einer Leiterbahn einer anderen Leiterfolie herzustellen. Um die Leiterbahn der Leiterfolie zu kontaktieren, wird ein mit Haltelaschen versehenes Kontaktteil auf die Leiterfolie aufgesetzt, dann auf die Leiterfolie aufgedrückt, so daß die Haltelaschen die Leiterfolie und die Leiterbahn durchschneiden und auf der Rückseite wieder austreten. Schließlich werden die Haltelaschen nach außen umgecrimpt, so daß das Kontaktteil fest mit der Leiterfolie verbunden ist. Die Kontaktierung der Leiterbahn erfolgt also mittels der Haltelaschen, die gegen die Leiterbahnen gepreßt werden.

Nachteilig bei dem bekannten Kontakt ist, daß sich die Qualität der erzielten Kontaktierung nach und nach verschlechtert, da das Kunststoffmaterial der Leiterfolie unter dem Druck, der von den Haltelaschen ausgeübt wird, langsam fließt. Somit verringert sich nach und nach die an der Kontaktierungsstelle wirkende Kontaktkraft, so daß zum einen die Gasdichtigkeit der Kontaktierungsstelle und zum anderen der erforderliche Kontaktdruck an der Kontaktierungsstelle nicht zuverlässig gewährleistet ist.

Aus der WO 98/11629 ist ein Kontaktelement mit einer Federlasche bekannt. Die Federlasche weist eine kugelförmige Andruckfläche auf, und das Kontaktelement ist mit einer kreisförmigen Aussparung versehen. Die Kontaktierung der Leiterbahn der Leiterfolie erfolgt im Bereich der kreisförmigen Andrucklinie zwischen dem Rand der Aussparung und der Andruckfläche.

Die Aufgabe der Erfindung besteht somit darin, einen Kontakt für Leiterfolien zu schaffen, der die Qualität der Kontaktierung auch über sehr lange Zeiträume gewährleistet und gleichzeitig für große Stromstärken geeignet ist.

Zu diesem Zweck ist erfindungsgemäß ein Kontakt für Leiterfolien vorgesehen, die mindestens eine Leiterbahn enthalten, mit einem Andruckelement, das mit einem Vorsprung versehen ist, der eine durchgehende Andruckfläche aufweist, und mit einem Gegendruckelement, das mit einer Aussparung versehen ist, deren Kontur an die Gestalt der Andruckfläche angepaßt ist, wobei der Vorsprung elastisch gegen das Gegendruckelement beaufschlagt wird, so daß eine zu kontaktierende Leiterfolie zwischen der Andruckfläche und dem Rand der Aussparung eingespannt wird. Die Erfindung beruht im Grundgedanken darauf, eine Linienberührung der Leiterbahn des Kontaktelementes mit einer elastischen Beaufschlagung zu kombinieren. Die Linienberührung sorgt dafür, daß die Kontaktierung entlang präzise definierter Bereiche der Leiterbahn erfolgt. Dies ist deshalb von großer Bedeutung, weil eine für die jeweilige Anwendung als vorteilhaft erkannte Flächenpressung an der Leiterbahn nur dann eingehalten werden kann, wenn die Kontaktfläche bekannt ist. Die elastische Beaufschlagung des Vorsprunges gegen den Rand der Aussparung im Gegendruckelement dient dazu, die einmal eingestellte Kontaktkraft auch dann beizubehalten, wenn die Leiterfolie unter der aufgebrachten Kontaktkraft langsam zu fließen beginnt.

Vorzugsweise ist vorgesehen, daß die Andruckfläche die Form einer Pyramide oder eines Pyramidenstumpfes hat und die Aussparung eine an den Querschnitt der Pyramide angepaßte, polygonale Form hat. Alternativ ist vorgesehen, daß die Andruckfläche die Form eines Ellipsoids oder eines Ellipsoid-Abschnittes hat und die Aussparung ellipsenförmig ist. Der Vorteil dieser Gestaltung besteht darin, daß sich bezogen auf die "Grundfläche" der Aussparung eine vergleichsweise lange Linienberührung zwischen dem Rand der Aussparung und der Andruckfläche ergibt, insbesondere länger als bei einer kreisförmigen Aussparung. In Anbetracht der Tatsache, daß die meisten Kontakte rechteckig sind, kann bei der Verwendung einer elliptischen oder langgestreckt rechteckigen Aussparung bei gleicher Breite des Kontakts eine sehr viel größere Berührfläche erzielt werden als bei einer kreisförmigen Aussparung.

Alternativ ist jedoch auch denkbar, die bereits aus dem Stand der Technik bekannte kreisförmige Aussparung zusammen mit einer kugelförmigen Andruckfläche zu verwenden, wobei sich dann allerdings nicht der oben erwähnte Vorteil der optimalen Flächennutzung ergibt.

Gemäß einer Ausführungsform der Erfindung ist vorgesehen, daß das Andruckelement und das Gegendruckelement aus Blech bestehen, wobei der Vorsprung durch eine Prägung am Andruckelement und die Aussparung durch eine gestanzte Öffnung im Gegendruckelement gebildet ist. Bei dieser Ausführungsform ergeben sich sehr geringe Herstellungskosten für den Anschlußkontakt.

Vorzugsweise sind das Andruckelement und das Gegendruckelement durch Haltelaschen, die beiderseits des Vorsprunges und der Aussparung angeordnet sind, aneinander befestigt, so daß die Eigenelastizität der beiden Elemente den Vorsprung gegen die Aussparung beaufschlagt. Die Haltelaschen ermöglichen es mit vergleichsweise einfachen Mitteln, die beiden Elemente aneinander zu befestigen. Vorzugsweise sind die Haltelaschen so ausgestaltet, daß sie die Leiterfolie automatisch durchschneiden, so daß keine entsprechenden Öffnungen vorgestanzt werden müssen.

Das Andruckelement und das Gegendruckelement können einstückig miteinander ausgebildet sein. Dies erleichtert die Montage, da nur ein einziges Teil gehandhabt werden muß. Zur Montage wird vorzugsweise eines der beiden Elemente an der Leiterfolie angeordnet und dann das andere Element um 180° umgebogen, so daß es auf die Leiterfolie zurückgefaltet wird und gegenüber dem anderen Element liegt. Der Biegebereich, in welchem das Andruckelement mit dem Gegendruckelement verbunden ist, ist vorzugsweise am Ende einer Kontaktlasche des Kontaktes gebildet, die von der Leiterfolie absteht und die Kontaktierung des Kontaktes beispielsweise mittels eines Kabelschuhs ermöglicht.

Gemaß einer zweiten Ausführungsform ist vorgesehen, daß das Andruckelement eine federnde Lasche ist, die an einem isolierenden Gehäuse angebracht ist und an deren freien Ende der Vorsprung ausgebildet ist, und daß das Gegendruckelement eine Kontaktzunge ist, in der die Aussparung ausgestanzt ist. Bei dieser Ausführungsform ist der Kontakt nach Art eines Steckers mit einem Gehäuse ausgebildet, der sehr gut greifbar ist und in einen zugeordneten Anschluß eingesteckt werden kann.

Vorzugsweise ist die federnde Lasche mit einer Arretiernase versehen ist, die mit einer Arretieraussparung in der Kontaktzunge zusammenwirken kann. Auf diese Weise ist eine Zugentlastung gebildet.

Vorteilhafterweise ist vorgesehen, daß das Gehäuse mit einer Aussparung für eine Blattfeder versehen ist, die nachträglich eingeschoben werden kann und den Vorsprung gegen die Aussparung beaufschlagt. Dies ermöglicht, die Leiterfolie zunächst frei in den Kontakt einzuschieben, bis sie ihre korrekte Lage eingenommen hat. Erst dann wird durch das Einschieben der Blattfeder eine Spannkraft erzeugt, welche zum einen die erforderliche Kontaktkraft bereitstellt und zum anderen die Leiterfolie in dem Gehäuse einspannt. Durch die funktionale und konstruktive Trennung der Andruckfläche von der Federwirkung kann durch Auswahl einer geeigneten Blattfeder die Kontaktkraft an die jeweils zweckmäßige Kontaktkraft unabhängig von der Ausgestaltung der Kontaktzunge angepaßt werden.

Unabhängig von der jeweiligen Ausführungsform sind die Andruckfläche und die Aussparung vorzugsweise so dimensioniert, daß die Länge des Randes der Aussparung etwa gleich der Breite der zu kontaktierenden Leiterbahn ist. Wenn beispielsweise eine quadratische Aussparung verwendet wird, wird deren Breite so gewählt, daß sie in der Größenordnung von knapp einem Viertel der Breite der zu kontaktierenden Leiterbahn liegt. Eine solche Bemessung hat sich für die Stromführung im Bereich des Überganges vom Kontakt zur Leiterbahn als vorteilhaft herausgestellt.

Vorteilhafte Ausgestaltungen der Erfindung ergeben sich aus den Unteransprüchen.

Die Erfindung wird nachfolgend unter Bezugnahme auf zwei Ausführungsformen beschrieben, die in den beigefügten Zeichnungen dargestellt sind. In diesen zeigen:
- Figur 1 einen Kontakt gemäß einer ersten Ausführungsform der Erfindung in einer Draufsicht;
- Figur 2 den Kontakt von Figur 1 in einer Seitenansicht;
- Figur 3 den Kontakt von Figur 1 in einer Unteransicht;
- Figur 4 einen Schnitt entlang der Ebene IV-IV durch den Kontakt von Figur 1 in vergrößertem Maßstab;
- Figur 4a eine Prinzipskizze der bei dem Kontakt wirkenden Klemmkräfte; und
- Figur 5 einen Kontakt gemäß einer zweiten Ausführungsform in einem Schnitt.

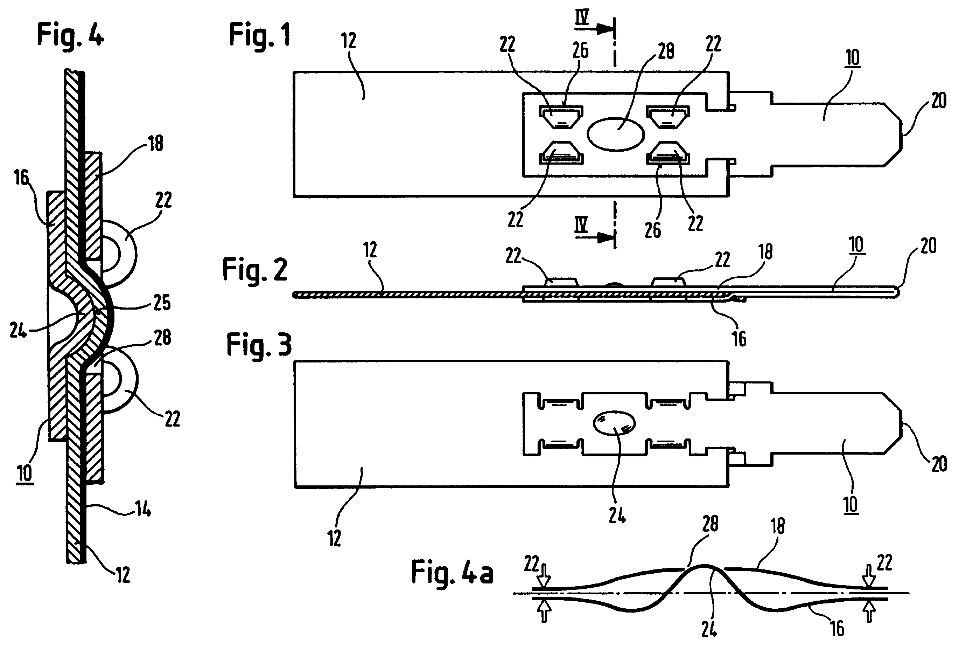

In den Figuren 1 bis 4 ist ein Kontakt gemäß einer ersten Ausführungsform gezeigt. Der Kontakt 10 dient dazu, eine Leiterbahn 14 einer Leiterfolie 12 zu kontaktieren. Die Leiterbahn 14 liegt in dem Bereich, in welchem der Kontakt 10 angreift, frei; falls eine Isolationsschicht vorgesehen ist, muß diese vor der Anbringung des Kontaktes entfernt werden.

Der Kontakt 10 besteht aus einem Andruckelement 16 und einem Gegendruckelement 18, die beide aus Blech bestehen und durch einen Biegeabschnitt 20 einstückig miteinander verbunden sind. Das Andruckelement 16 ist mit vier Haltelaschen 22 sowie einem Vorsprung 24 versehen. Der Vorsprung ist etwa mittig zwischen den Haltelaschen angeordnet und hat in einem Querschnitt betrachtet eine solche Form, daß seine Oberfläche einen Abschnitt eines Ellipsoids bildet. Diese Oberfläche stellt eine Andruckfläche 25 für die Leiterfolie dar.

Das Gegendruckelement 18 ist mit vier Öffnungen 26 für die Haltelaschen 22 versehen sowie mit einer Aussparung 28, die hier eine elliptische Gestalt hat.

Der Kontakt 10 besteht aus Blech und wird vorzugsweise ausgestanzt. Dabei können die Öffnungen 26 sowie die Aussparung 28 in demselben Herstellungsschritt ausgebildet werden. Der Vorsprung 24 wird vorzugsweise durch eine Prägung des Andruckelementes ausgebildet.

Gemäß einer nicht dargestellten Weiterbildung der Erfindung ist es möglich, mehrere Kontakte im Ausgangszustand aneinanderhängend auszustanzen, so daß die Kontakte in Bandform einer Verarbeitungsmaschine zugeführt werden können. In dieser werden dann lediglich die Verbindungsstege zwischen den einzelnen Kontakten getrennt.

Das Anschließen des Kontaktes an die Leiterbahn geschieht in folgender Weise: Das Andruckelement 16 wird an der Leiterfolie 12 auf der Seite angelegt, die nicht mit der Leiterbahn 14 versehen ist. Dann wird die Leiterfolie 12 gegen das Andruckelement gedrückt, so daß sich die Haltelaschen 22, die an ihrem freien Ende angeschrägt ausgebildet sind, durch die Leiterfolie schneiden. Anschließend wird das Gegendruckelement durch Umbiegen im Bereich des Biegeabschnittes 20 auf das Andruckelement und die an diesem angeordnete Leiterfolie zurückgefaltet, so daß sich die Haltelaschen 22 durch die Öffnungen 26 hindurch erstrecken. Abschließend werden die Haltelaschen 22 umgecrimpt, so daß sie sich an dem Gegendruckelement 18 abstützen und das Andruckelement fest am Gegendruckelement halten.

Der Vorsprung 24 sowie die Aussparung 28 sind unter Berücksichtigung der Dicke und der Steifigkeit der Leiterfolie so dimensioniert, daß der Vorsprung 24 nicht vollständig in die Aussparung 28 eintauchen kann, also im montierten Zustand ein Spalt zwischen dem Andruckelement 16 und dem Gegendruckelement 18 im Bereich des Randes der Aussparung verbleibt. Da aber die Haltelaschen 22 im Abstand vom Vorsprung 24 angeordnet sind und das Andruckelement und das Gegendruckelement 18 im Bereich der Haltelaschen fest aneinandergedrückt werden, werden das Andruckelement 16 und das Gegendruckelement 18 elastisch gebogen, so daß sich eine Vorspannung ergibt. Dies ist in Figur 4a schematisch übertrieben dargestellt. Es ergibt sich somit am Rand der Aussparung 28 eine definierte Kontaktkraft zwischen dem Gegendruckelement 18 und der Leiterbahn 14. Aufgrund der elastischen Vorspannung des Andruckelementes 16 und des Gegendruckelementes 18 bleibt dieser Kontaktkraft auch erhalten, wenn es mit der Zeit zu einem geringfügigen Fließen der Leiterfolie unter der wirkenden Kontaktkraft kommt, so daß sich die Dicke der Leiterfolie geringfügig verringert.

Die Aussparung 28 ist so bemessen, daß der Rand der Aussparung, der den eigentlichen Kontaktbereich zur Leiterbahn 14 bereitstellt, eine Länge hat, die etwa gleich der Breite der zu kontaktierenden Leiterbahn ist.

Abweichend von der dargestellten elliptischen Aussparung kann auch eine polygonförmige Aussparung verwendet werden, Im Hinblick auf die optimale Flächennutzung ist eine langgestreckt rechteckige Aussparung besonders geeignet. Die Andruckfläche hat in einem solchen Fall selbstverständlich eine komplementäre Form, insbesondere die Form eines Pyramidenstumpfes.

Nach der Kontaktierung der Leiterbahn kann am Kontakt 10 die weitere Kontaktierung beispielsweise mittels eines Kabelschuhes erfolgen, der auf die von der Leiterfolie abstehende Lasche, in deren Bereich der Biegeabschnitt 20 angeordnet ist, aufgeschoben wird. Alternativ kann diese Lasche beispielsweise mit einer Öffnung für einen Schraubbolzen versehen werden.

Gemäß einer anderen, ebenfalls nicht dargestellten Weiterbildung der Erfindung ist es möglich, mehrere Aussparungen nebeneinanderliegend im jeweiligen Kontakt auszubilden. Auf diese Weise erhöht sich die Berührfläche zwischen Kontakt und Leiterbahn, so daß höhere Ströme übertragen werden können.

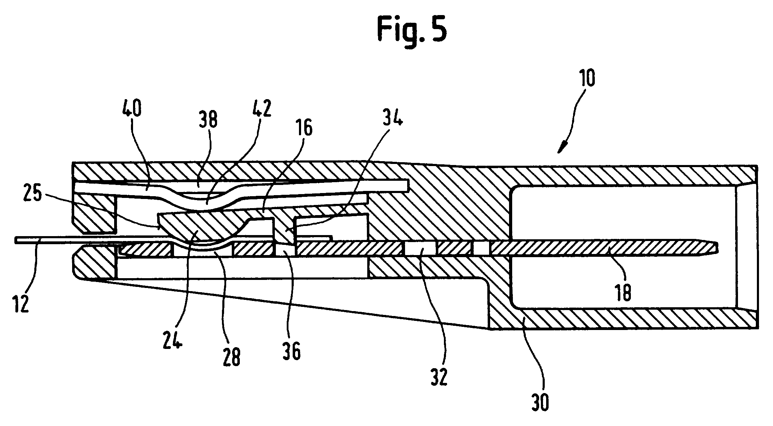

In Figur 5 ist ein Kontakt gemäß einer zweiten Ausführungsform gezeigt. Für die Bauelemente, die bereits von der ersten Ausführungsform bekannt sind, werden dieselben Bezugszeichen verwendet, und es wird auf die obigen Erläuterungen verwiesen. Bei der zweiten Ausführungsform weist der Kontakt 10 ein Gehäuse 30 auf, in welchem das Gegendruckelement 18 angeordnet ist. Dieses ist als Kontaktzunge ausgebildet, die in dem Gehäuse 30 aufgenommen ist. Um den Halt der Kontaktzunge im Gehäuse 10 zu verbessern, können Verriegelungsöffnungen 32 vorgesehen sein.

Das Andruckelement 16 ist bei der zweiten Ausführungsform als federnde Lasche ausgebildet, an deren freien Ende der Vorsprung 24 ausgebildet ist. Die Andruckfläche 25 des Vorsprungs 24 ist hier als Schichtfläche eines Ellipsoids ausgebildet. An der federnden Lasche ist eine Arretiernase 34 ausgebildet, die mit einer im Gegendruckelement 18 ausgebildeten Arretieraussparung 36 zusammenwirken kann.

Im Gehäuse ist eine Aussparung 38 vorgesehen, in die eine Blattfeder 40 eingeschoben werden kann. Diese ist mit einem Biegeabschnitt 42 versehen, der an der von der Leiterfolie 12 abgewandten Rückseite des Vorsprunges angreifen kann.

Der beschriebene Kontakt wird in der folgenden Weise montiert: Zunächst wird die Isolation der Leiterbahn in dem Bereich, in welchem der Kontakt aufgeschoben werden soll, entfernt. Gleichzeitig wird in der Leiterfolie eine Öffnung ausgestanzt, in die später die Arretiernase eingreifen kann. Anschließend wird die Leiterfolie in das Gehäuse eingeschoben. Dann wird die Blattfeder in die Aussparung 38 eingeschoben, wodurch das Andruckelement 16 mit dem Vorsprung 24 elastisch gegen die Leiterfolie und das Gegendruckelement 18 gedrückt wird. Der Vorsprung drückt nun die Leiterfolie mit der Leiterbahn gegen den Rand der Aussparung 28, so daß die Kontaktierung gewährleistet ist. Bei der Auslenkung des Andruckelementes greift die Arretiernase durch die in der Leiterfolie gestanzte Öffnung in die Arretieraussparung 36 ein, so daß die Leiterfolie in dem Gehäuse festgelegt und eine Zugentlastung gebildet ist.

Die Blattfeder gewährleistet, daß ungeachtet eines etwaigen Fließens der Leiterfolie eine konstante Kontaktkraft zwischen der Andruckfläche 25 und dem Rand der Aussparung 28 gewährleistet ist.

Bei beiden Ausführungsformen ist für die erzielte Kontaktierung nur der Flächenbereich der Leiterbahn relevant, der von der Andruckfläche gegen den Rand der Aussparung gedrückt wird. Der Vorsprung kann außerhalb dieses Bereiches nahezu beliebig gestaltet sein; es kann sogar hingenommen werden, daß die Leiterfolie mit der Leiterbahn innerhalb der Aussparung reißt, wenn sie dem von dem Vorsprung vorgegebenen Verlauf nicht folgen kann. Dies ist ohne Auswirkung auf die Kontaktierung, da die Stromleitung unmittelbar vom Rand der Aussparung nach außen in die Leiterbahn erfolgt.

## Patentansprüche

1. Kontakt für Leiterfolien, die mindestens eine Leiterbahn (14) enthalten, mit einem Andruckelement (16), das mit einem Vorsprung (24) versehen ist, der eine durchgehende Andruckfläche (25) aufweist, und mit einem Gegendruckelement (18), das mit einer Aussparung (28) versehen ist, deren Kontur an die Gestalt der Andruckfläche angepaßt ist, wobei der Vorsprung elastisch gegen das Gegendruckelement beaufschlagt wird, so daß eine zu kontaktierende Leiterfolie zwischen der Andruckfläche (25) und dem Rand der Aussparung (28) eingespannt wird.

2. Kontakt nach Anspruch 1, dadurch gekennzeichnet, daß die Andruckfläche 25) die Form einer Pyramide oder eines Pyramidenstumpfes hat und die Aussparung (28) eine an den Querschnitt der Pyramide angepaßte, polygonale Form hat.

3. Kontakt nach Anspruch 1, dadurch gekennzeichnet, daß die Andruckfläche (25) die Form eines Ellipsoids oder eines Ellipsoid-Abschnittes hat und die Aussparung (28) ellipsenförmig ist.

4. Kontakt nach einem der vorhergehenden Ansprüche, dadurch gekennzeichnet, daß das Andruckelement (16) und das Gegendruckelement (18) aus Blech bestehen, wobei der Vorsprung (24) durch eine Prägung am Andruckelement und die Aussparung (28) durch eine gestanzte Öffnung im Gegendruckelement gebildet ist.

5. Kontakt nach Anspruch 4, dadurch gekennzeichnet, daß das Andruckelement und das Gegendruckelement durch Haltelaschen (22), die beiderseits des Vorsprunges und der Aussparung angeordnet sind, aneinander befestigt sind, so daß die Eigenelastizität der beiden Elemente den Vorsprung (24) gegen die Aussparung (28) beaufschlagt.

6. Kontakt nach einem der Ansprüche 4 und 5, dadurch gekennzeichnet, daß das Andruckelement (16) und das Gegendruckelement (18) einstückig miteinander ausgebildet sind.

7. Kontakt nach einem der Ansprüche 1 und 2, dadurch gekennzeichnet, daß das Andruckelement (16) eine federnde Lasche ist, die an einem isolierenden Gehäuse (30) angebracht ist und an deren freien Ende der Vorsprung (24) ausgebildet ist, und daß das Gegendruckelement (18) eine Kontaktzunge ist, in der die Aussparung (28) ausgestanzt ist.

8. Kontakt nach Anspruch 7, dadurch gekennzeichnet, daß die federnde Lasche mit einer Arretiernase (34) versehen ist, die mit einer Arretieraussparung (36) in der Kontaktzunge zusammenwirken kann.

9. Kontakt nach einem der Ansprüche 7 und 8, dadurch gekennzeichnet, daß das Gehäuse mit einer Aussparung (38) für eine Blattfeder (40) versehen ist, die nachträglich eingeschoben werden kann und den Vorsprung gegen die Aussparung beaufschlagt.

10. Kontakt nach einem der vorhergehenden Ansprüche, dadurch gekennzeichnet, daß die Länge des Randes der Aussparung (28) etwa gleich der Breite der zu kontaktierenden Leiterbahn (14) ist.

11. Kontakt nach einem der vorhergehenden Ansprüche, dadurch gekennzeichnet, daß zwei Aussparungen und zwei Andruckflächen vorgesehen sind, die nebeneinander liegen.
